Europäisches Patentamt

European Patent Office    (11) Publication number: **0 284 061**

Office européen des brevets    **A2**

## (12) EUROPEAN PATENT APPLICATION

(21) Application number: 88104733.6

(22) Date of filing: 24.03.88

(51) Int. Cl.⁴: **H01L 39/24** , H01L 39/12

(30) Priority: 24.03.87 JP 69366/87
27.03.87 JP 74792/87

(43) Date of publication of application:
**28.09.88 Bulletin 88/39**

(84) Designated Contracting States:
**DE FR GB**

(71) Applicant: SUMITOMO ELECTRIC INDUSTRIES
LIMITED
No. 15, Kitahama 5-chome Higashi-ku
Osaka-shi Osaka 541(JP)

(72) Inventor: Nagata, Masayuki c/o Osaka Works
of
Sumitomo Electric Ind. Ltd 1-3, Shimaya
1-chome
Konohana-ku Osaka-shi Osaka-fu(JP)
Inventor: Yamada, Yuichi c/o Osaka Works of
Sumitomo Electric Ind. Ltd 1-3, Shimaya
1-chome
Konohana-ku Osaka-shi Osaka-fu(JP)

(74) Representative: Hansen, Bernd, Dr.rer.nat. et
al
Hoffmann, Eitle & Partner Patentanwälte
Arabellastrasse 4 Postfach 81 04 20
D-8000 München 81(DE)

(54) Ceramic oxide superconductive composite material.

㊼ A ceramic oxide superconductive composite material which comprises at least two kinds of ceramic oxide superconductors having different superconductive properties from each other is provided.

EP 0 284 061 A2

## CERAMIC OXIDE SUPERCONDUCTIVE COMPOSITE MATERIAL

### BACKGROUND OF THE INVENTION

#### Field of the Invention

The present invention relates to a ceramic oxide superconductive composite material which comprises at least two kinds of ceramic oxide superconductors having different superconductive properties from each other.

#### Description of Related Art

A superconductor exhibits complete diamagnetism under superconductive conditions and has no potential difference therein in spite of flow of stationary current in therein. By using this characteristic of the superconductor, many applications of superconductors as mediums for electric current have been proposed.

Application fields of superconductor include versatile technical fields such as an electric power field (e.g. MHD power generation, power transmission, power storage, etc.), a motive power field (e.g. linear motor (magnetic letivation) trains, electromagnetic propulsion ships, etc.), and a measuring field in which the superconductor is used as a highly sensitive sensor for a magnetic field, a microwave, radiation and the like (e.g. NMR, therapy using $\pi$-meson, high energy physical experiment apparatus, etc.).

In addition, in the electronics including a Josephson element, the superconductor is expected to provide an element which can not only decrease consumed power but also work at a very high speed.

The superconductive phenomenon has been found in specific metals or organic compounds at extremely low temperatures. Namely, among classical superconductors, $Nb_3Ge$ is said to have the highest critical temperature Tc for superconductivity of 23.2K and this temperature has been considered as the upper limit of Tc for a long time.

Hitherto, to realize the superconductive phenomenon, a superconductor should be cooled to a temperature lower than Tc with liquid helium which has a boiling point of 4.2 K. However, the use of liquid helium greatly increases technical burden and cost because of necessity of a cooling system including an apparatus for liquefying helium, which prevents practical application of the superconductor.

Recently, it was reported that a sintered material comprising oxides of elements of IIa or IIIa group of the periodic table can act as a superconductor at a high critical temperature and is expected to accelerate practical application of superconductor technology. From already available reports, compound oxides having a crystal structure similar to the perovskite crystal structure such as $(La,Ba)_2CuO_4$ or $(La,Sr)_2CuO_4$ are known as superconductors having high Tc. These compound oxides have Tc of 30 to 50 K, which is far higher than that of the classical superconductors. In addition, a Ba-Y-Cu type superconductor is reported to have Tc higher than the liquid nitrogen temperature.

However, the known ceramic oxide superconductor has a single critical temperature and behaves as a superconductor at or below the critical temperature, and at a temperature higher than the critical temperature, it behaves as a semiconductor and has a constant resistivity or a resistivity which slightly decreases as the temperature rises.

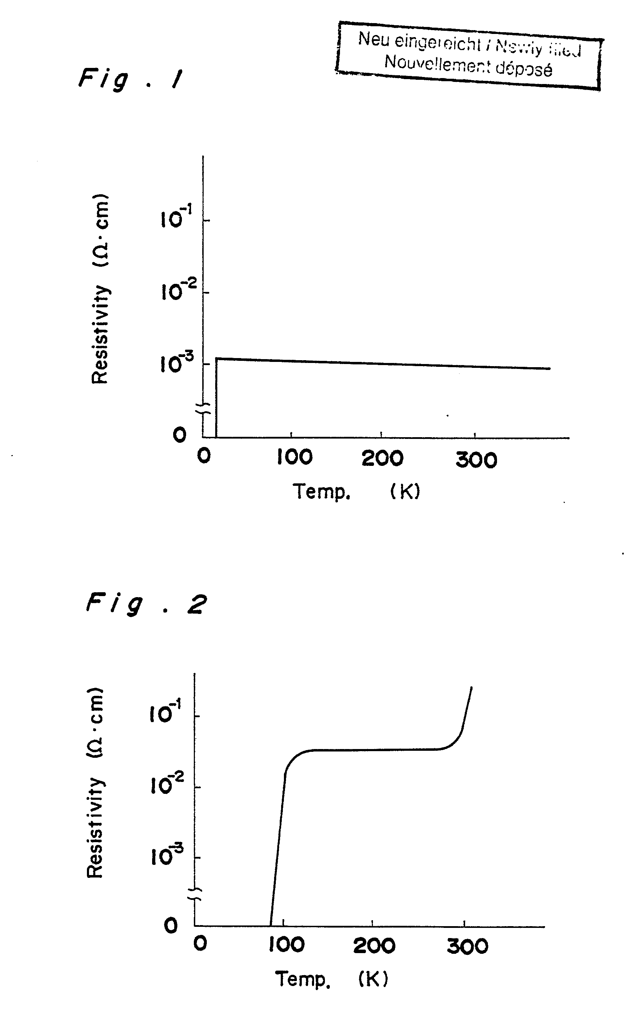

One of the known ceramic oxide superconductors, $LiTi_2O$ has a critical temperature of 14K, so that it has zero resistance at a temperature lower than 14K and it has a constant resistivity of about $1 \times 10^{-3}$ ohm.cm at a temperature higher than 14K (see Fig. 1).

The superconductor having a single critical temperature can be used for making a very high speed switching element and applied for memorizing or processing a binary condition by on-off control action.

Since the element made of such superconductor cannot memorize or process a multi-valued condition equal to or larger than three-values, a logic circuit comprising two or more elements should be constructed to memorize or process the multi-valued condition.

For example, to realize a conversion element for converting a continuous level to a step-wise level, usually a very complicated logical conversion circuit, which occupies a large area, is required.

If the multi-valued condition were memorized or processed by a small single element, great advantage would be obtained from the view point of circuit construction and integration and such element would be highly valuable in application.

It is known that the presence of oxygen in a sintering atmosphere greatly influences properties of superconductor in the preparation of ceramic oxide superconductor. For example, the raw materials are sintered in the air, a surface part of sintered material, for example, a surface layer of thickness of 0.5 mm from the surface which readily contacts the air has superior superconductive characteristics, namely higher critical temperature than inner parts of sintered material, although non-surface parts of sintered material may have superconductive characteristics.

Such difference of the properties may arise from delicate difference of composition and or crystalline structure between two parts which are caused by the difference of sintering conditions and so on. The superconductive characteristics of such ceramic oxide superconductor have not been studied and no attempt has been made for utilizing such characteristics in an element for memorizing or processing the multi-valued condition.

## SUMMARY OF THE INVENTION

An object of the present invention is to provide a ceramic oxide superconductor which can be used for producing an element for memorizing or processing the multi-valued condition.

Accordingly, the present invention provides a ceramic oxide superconductive composite material which comprises at least two kinds of ceramic oxide superconductors having different superconductive properties from each other.

## BRIEF DESCRIPTION OF DRAWINGS

Fig. 1 is a graph showing temperature dependency of resistivity found in $LiTi_2O$, and

Fig. 2 is a graph showing temperature dependency of resistivity found in the ceramic oxide superconductive composite material of the present invention.

## DETAILED DESCRIPTION OF THE INVENTION

The ceramic oxide superconductor comprises (1) at least one element selected from the elements of Ia, IIa and IIIa groups of the periodic table, (2) at least one element selected from the elements of Ib, IIb, IIIb, IVa and VIIIa groups of the periodic table, and (3) at least one element selected from the group consisting of oxygen, boron, carbon, nitrogen, fluorine and sulfur.

Examples of the Ia group elements are Li, Na, K, Rb, Cs and Fr, and examples of the Ib group elements are Cu, Ag and Au.

Examples of the IIa group elements are Be, Mg, Ca, Sr, Ba and Ra, and examples of the IIb group elements are Zn, Cd and the like.

Examples of the IIIa group elements are Sc, Y and lanthanoids (e.g. La, Ce, Pr, Nd, Pm, Sm, Eu, Gd, Tb, Dy, Ho, Er, Tm, Yb and Lu) and actinoids (e.g. Ac), and examples of IIIb group elements are Al, Ga, In and Tl.

Among the above exemplified elements, those selected from the Ib group elements. the IIa group elements, the IIIa group elements, lanthanoids, oxygen, carbon and sulfur are preferred. Among the Ib group elements. Cu and Ag are more preferred. among the IIa group elements. Sr and Ba are more preferred and among the IIIa group elements, Sc and Y are more preferred.

Preferably, the ceramic oxide superconductor has a composition of the formula:

$$(M^1{}_{1-x}M^2{}_x)M^3{}_yM^4{}_z \quad (I)$$

wherein $M^1$ is at least one element selected from the IIa group elements, $M^2$ is at least one element selected from the IIIa group elements, $M^3$ is at least one element selected from Ib, IIb, IIIb, IVa and VIIIa group elements, $M^4$ is at least one element selected from the group consisting of oxygen, boron, carbon, nitrogen, fluorine and sulfur, x is an atomic ratio of $M^2$ to $(M^1 + M^2)$ and not smaller than 0.1 and not larger than 0.9 ($0.1 \leq x \leq 0.9$), and y and z are atomic ratios of $M^3$ and $M^4$ to $(M^1 + M^2)$ and not smaller than 0.4 and not larger than 3.0, and not smaller than 1 and not larger than 5, respectively ($0.4 \leq y \leq 3.0$ and $1 \leq z \leq 5$).

As the element $M^1$ of the formula (I), Ca, Sr, Ba and Ra, particularly Ba and Sr are preferred. As the element $M^2$, Sc, Y, lanthanoids and actinoids, particularly, Y, La, Ce, Nd and Yh are preferred. As the element $M^3$, Cu, Ag, Zn, Cd, Ga, In, Fe, Co, Ni and Ti, particularly Cu, Fe, Co, Ni and Ti are preferred.

Examples of the superconductor having the above composition are Ba-Y-Cu-O, Ba-La-Cu-O, Sr-La-Cu-O type superconductors. The ratios of elements are arbitrarily selected in the ranges of the above definitions.

When a combination of Y-Ba, La-Ba or Sr-Ba is selected as a combination of $M^1$ and $M^2$, the atomic ratio of $Y/(Y + Ba)$ is preferably from 0.06 to 0.9, the atomic ratio of $Ba/(La + Ba)$ is preferably from 0.04 to 0.96, and the atomic ratio of $Sr/(La + Sr)$ is preferably from 0.05 to 0.1, more preferably from 0.05 to 0.1.

Preferably, the atomic ratios of the element $M^3$ and oxygen to $(M^1 + M^2)$ are from 1:0.4 to 1:3.0 and from 1:1 to 1:5, respectively. At these atomic ratios, the superconductor may have a crystal structure of perovskite type, quasi-perovskite type such as oxygen-defect perovskite type which has an orthorhombic structure.

According to the present invention, ceramic oxide superconductive composite material comprises at least two kinds of such ceramic oxide superconductors which have different superconductive properties from each other. The ratio of the two or more kinds of ceramic oxide superconductors may be selected from a wide range depending on the required properties of the ceramic oxide superconductive composite material.

## PREFERRED EMBODIMENTS OF THE INVENTION

The present invention will be illustrated by following Example.

### Example

By selecting Ba as the II group element, Y as the III group element and Cu as the I group element, $Y_2O_3$ powder (3.78 g), a mixture of $BaCO_3$ powder (14.54 g) and CuO powder (7.99 g) was pressed under pressure of 1,000 Atm. ($kg/cm^2$) and then sintered in the air at 950°C for 12 hours. Resistivity of the prepared superconductor material was measured by a four probe method. The result is shown in Fig. 1. A great drop in resistivity was found around 300K, which may be attributed to the fact that superconductive state would be partially realized and the resistivity became 0 (zero) around 80K.

A sample of the prepared superconductor material was analyzed by X-ray diffraction and two phases were identified, one of which might be an orthrhombic phase having an oxygen-defect layer perovskite structure but the other of which was not clearly identified from the results of the X-ray diffraction.

When the above experiment is repeated with changing the compositions of the raw material powder, ceramic oxide superconductive materials having different critical temperatures are produced. That is, when a content of at least one of the constituent elements deviates from the normal atomic ratio, for example, 1:2:3 for Y:B:Cu, the ceramic oxide superconductor having two or more phases can be prepared.

By combining crystalline structures or phases of the ceramic oxide superconductive material having different superconductive properties in one material as minimum units, a superconductive material which has resistivity having a step-wise temperature dependency can be obtained. Further, since the ceramic oxide superconductive material of the present invention has different critical current density or critical magnetic field from part to part, it exhibits step-wise correspondence to change of current intensity or magnetic field intensity.

When an element is made of the ceramic oxide superconductive composite material having multiple superconductive characteristics, it can be used for realizing an electronic device which has multi-value conditions.

The present invention is not limited to a specific arangement of the plural phases. In the ceramic oxide superconductor of the present invention, since the plural phases are suitably mixed and the superconductive properties such as $T_c$, $H_{c2}$ and energy gaps vary from part to part, an interface between the phases acts as a pinning point so that magnetic flux flow caused by the Lorentz's force which is generated by current flowd through the superconductor in the magnetic field, which results in greatly increased critical current and critical current density.

## Claims

1. A ceramic oxide superconductive composite material which comprises at least two kinds of ceramic oxide superconductors having different superconductive properties from each other.

2. The ceramic oxide superconductive composite material according to claim 1, wherein the superconductor comprises (1) at least one element selected from the elements of Ia, IIa and IIIa groups of the periodic table, (2) at least one element selected from the elements of Ib, IIb, IIIb, IVa and VIIIa groups of the periodic table, and (3) at least one element selected from the group consisting of oxygen, boron, carbon, nitrogen, fluorine and sulfur.

3. The ceramic oxide superconductive composite material according to claim 2, wherein the superconductor has a composition of the formula:

$$(M^1_{1-x}M^2_x)M^3_yM^4_z \qquad (I)$$

wherein $M^1$ is at least one element selected from the IIa group elements, $M^2$ is at least one element selected from the IIIa group elements, $M^3$ is at least one element selected from Ib, IIb, IIIb, IVa and VIIIa group elements, $M^4$ is at least one element selected from the group consisting of oxygen, boron, carbon, nitrogen, fluorine and sulfur, x is not smaller than 0.1 and not larger than 0.9, y is not smaller than 0.4 and not larger than 3.0, and z is not smaller than 1 and not larger than 5.

4. The ceramic oxide superconductive composite material according to claim 3, wherein $M^1$ is Ba, $M^2$ is an element selected from the group consisting of Sc, Y and La.

Fig . 1

Fig . 2